(19) Europäisches Patentamt / European Patent Office / Office européen des brevets

(11) **EP 3 923 469 A1**

(12) **EUROPEAN PATENT APPLICATION**
published in accordance with Art. 153(4) EPC

(43) Date of publication:
**15.12.2021 Bulletin 2021/50**

(21) Application number: **19924376.7**

(22) Date of filing: **09.04.2019**

(51) Int Cl.:
**H03B 5/08** (2006.01)          **H03B 5/12** (2006.01)

(86) International application number:
**PCT/CN2019/081920**

(87) International publication number:
**WO 2020/206609 (15.10.2020 Gazette 2020/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Longgang**
**Shenzhen, Guangdong 518129 (CN)**

(72) Inventor: **ZHANG, Jinhai**
**Shenzhen, Guangdong 518129 (CN)**

(74) Representative: **Epping - Hermann - Fischer**
**Patentanwaltsgesellschaft mbH**
**Schloßschmidstraße 5**
**80639 München (DE)**

(54) **DIFFERENTIAL OSCILLATOR**

(57) This application provides a differential oscillator. The differential oscillator includes: a power line, disposed on a chip; a ground line, disposed on the chip and parallel to the power line; a main resonant circuit, disposed on the chip and including a first inductor and a second inductor that are connected in parallel, where the first inductor and the second inductor are disposed on a side that is of the power line and that is far away from the ground line, and the main resonant circuit is connected to the power line; and a tail resonant circuit, disposed on the chip and connected to the main resonant circuit and the ground line. Inductors in the oscillator are disposed on two sides of the power line and the ground line. This ensures that both the power line and the ground line are a virtual "ground", and reduces a phase noise of the oscillator.

FIG. 3

EP 3 923 469 A1

## Description

## TECHNICAL FIELD

This application relates to the circuit field, and more specifically, to a differential oscillator.

## BACKGROUND

A clock is an important component of a communication system. A high-precision communication system has a comparatively high requirement for precision of a clock. An oscillator may be configured to generate a clock for a circuit. A high-quality oscillator is essential for implementing high-precision communication. For an alternating current signal, a conventional differential oscillator using a tail inductor resonance technology cannot ensure that both a power line and a ground line in a circuit of the oscillator are a virtual "ground". In other words, an alternating current impedance between the power line and the ground line is comparatively large. In the circuit of the oscillator, a capacitor and an inductor in a main resonant circuit, a capacitor and an inductor in a tail resonant circuit, and bulks of cross-coupled metal-oxide-semiconductor (metal-oxide-semiconductor, MOS) devices are connected to a power supply or a ground. The comparatively large alternating current impedance between the power line and the ground line results in failure to precisely determine an alternating current impedance of an element in the circuit. Therefore, it is difficult to ensure that the tail resonant circuit resonates at an oscillation frequency twice an oscillation frequency of the main resonant circuit. As a result, the differential oscillator has a comparatively large phase noise.

## SUMMARY

This application provides a differential oscillator. Inductors in the differential oscillator are disposed on two sides of a power line and a ground line, to reduce a distance between the power line and the ground line. This ensures that both the power line and the ground line are a virtual "ground", and reduces a phase noise of the differential oscillator.

According to a first aspect, a differential oscillator is provided. The differential oscillator includes: a power line, disposed on a chip; a ground line, disposed on the chip and parallel to the power line; a main resonant circuit, disposed on the chip and including a first inductor and a second inductor, where the first inductor and the second inductor are disposed on a side that is of the power line and that is far away from the ground line, and the main resonant circuit is connected to the power line; and a tail resonant circuit, disposed on the chip and connected to the main resonant circuit and the ground line.

Compared with a layout manner, of a conventional differential oscillator, in which an inductor of a main resonant circuit and an inductor of a tail resonant circuit are disposed between a power line and a ground line, a layout manner, of the differential oscillator in this embodiment of this application, in which the inductors in the main resonant circuit are disposed on the side that is of the power line and that is far away from the ground line can reduce a distance between the power line and the ground line. The comparatively small distance implements that a parasitic parameter generated by a decoupling capacitor disposed between the power line and the ground line has a comparatively small impedance. Therefore, an alternating current impedance between the ground line and the power line is reduced and the ground line and the power line approximate a virtual "ground". Many of devices in the differential oscillator are connected to the power line or the ground line. Alternating current parasitic parameters of the devices in the differential oscillator can be more precisely determined only when the alternating current impedance between the ground line and the power line is comparatively small. A difference between an oscillation frequency of the tail resonant circuit and the double of an oscillation frequency of the main resonant circuit can be reduced through proper design. This reduces a phase noise of the oscillator. When the distance between the ground line and the power line is comparatively small, a requirement of the differential oscillator for the decoupling capacitor is reduced.

With reference to the first aspect, in some possible implementations, the tail resonant circuit includes a tail inductor. The tail inductor includes a tail inductor body and a tail inductor connection portion. The tail inductor body is disposed on a side that is of the ground line and that is far away from the power line. The tail inductor connection portion is configured to connect to the tail inductor body and the main resonant circuit. The main resonant circuit and the tail resonant circuit are separately disposed on two sides of the power line and the ground line, to further reduce the distance between the power line and the ground line. This reduces the phase noise of the oscillator.

With reference to the first aspect, in some possible implementations, the distance between the ground line and the power line is less than or equal to a first preset value.

With reference to the first aspect, in some possible implementations, the differential oscillator further includes a decoupling capacitor. The decoupling capacitor is disposed between the ground line and the power line, and is connected to the power line and the ground line. When the decoupling capacitor is disposed between the ground line and the power line, it is easy to implement in a process, a parasitic effect can be reduced, and an occupied chip area can be reduced. Therefore, disposing a comparatively small decoupling capacitor between the ground line and the power line can meet a circuit design requirement. The comparatively small decoupling capacitor occupies a comparatively small area, and reduces occupied chip resources.

With reference to the first aspect, in some possible implementations, the tail inductor connection portion is disposed in parallel with the ground line, and the tail inductor connection portion is located between the tail inductor body and the ground line.

With reference to the first aspect, in some possible implementations, the differential oscillator further includes cross-coupled metal-oxide-semiconductor MOS transistors. The cross-coupled MOS transistors are configured to provide negative resistance for the main resonant circuit.

With reference to the first aspect, in some possible implementations, the main resonant circuit includes a first capacitor. The first capacitor includes a first fixed capacitor, a first MOS varactor, a second MOS varactor, and a second fixed capacitor that are connected in series. A sum of a capacitance of the first fixed capacitor and a capacitance of the first MOS varactor is equal to a sum of a capacitance of the second MOS varactor and a capacitance of the second fixed capacitor. The first fixed capacitor is connected to a gate of the first MOS varactor, and the second fixed capacitor is connected to a gate of the second MOS varactor. A control voltage is a bias voltage of a source and a drain of the first MOS varactor and a bias voltage of a source and a drain of the second MOS varactor. A first bias voltage provides a direct current bias for the gate of the first MOS varactor, a second bias voltage provides a direct current bias for the gate of the second MOS varactor, and the first bias voltage and the second bias voltage are bias voltages obtained from a supply voltage provided by a power line. The fixed capacitors and the MOS varactors are connected in series, and therefore implement voltage division by using the fixed capacitors and the MOS varactors. In this way, impact of a power supply noise on gate capacitances of the MOS varactors can be reduced. This reduces impact of the power supply noise on a frequency of the oscillator, and reduces the phase noise.

With reference to the first aspect, in some possible implementations, when the first bias voltage is within a first voltage range, a gate capacitance of the first MOS varactor that is in at least one voltage value state of the control voltage does not change with a voltage at a terminal at which the first fixed capacitor is connected to the first inductor. Impact of the power supply noise on the gate capacitance of the first MOS varactor can be reduced by biasing a gate voltage of the first MOS varactor to be within the first voltage range. This reduces impact of the power supply noise on the frequency of the oscillator, and reduces the phase noise.

With reference to the first aspect, in some possible implementations, capacitances of the first fixed capacitor and the second fixed capacitor are equal, process parameters of the first MOS varactor and the second MOS varactor are the same, and the first bias voltage and the second bias voltage are equal.

According to a second aspect, a differential oscillator is provided, including a main resonant circuit. The main resonant circuit includes a first fixed capacitor, a first metal-oxide-semiconductor MOS varactor, a second MOS varactor, and a second fixed capacitor that are connected in series between two differential output terminals of the oscillator. The first fixed capacitor is connected to a gate of the first MOS varactor, and the second fixed capacitor is connected to a gate of the second MOS varactor. A control voltage controls a bias voltage of a source and a drain of the first MOS varactor and a bias voltage of a source and a drain of the second MOS varactor. A first bias voltage provides a direct current bias for the gate of the first MOS varactor, a second bias voltage provides a direct current bias for the gate of the second MOS varactor, and the first bias voltage and the second bias voltage are bias voltages obtained from a supply voltage provided by the power line.

In a conventional differential oscillator, a capacitor array including MOS varactors forms a capacitor in a main resonant circuit. A noise from the power line affects gate voltages of the MOS varactors, resulting in a change in capacitances of the MOS varactors and causing a comparatively large phase noise. In this embodiment of this application, the fixed capacitors are added to be connected to the MOS varactors in series, and voltage division by using the fixed capacitors and the MOS varactors is implemented. In this way, impact of a power supply noise on gate capacitances of the MOS varactors can be reduced. This reduces impact of the power supply noise on a frequency of the oscillator, and reduces the phase noise.

With reference to the second aspect, in some possible implementations, when the first bias voltage is within a first voltage range, a gate capacitance of the first MOS varactor that is in at least one state of the control voltage does not change with an output voltage of the differential oscillator.

With reference to the second aspect, in some possible implementations, capacitances of the first fixed capacitor and the first fixed capacitor are equal, process parameters of the first MOS varactor and the second MOS varactor are the same, and the first bias voltage and the second bias voltage are equal.

With reference to the second aspect, in some possible implementations, the differential oscillator further includes cross-coupled metal-oxide-semiconductor MOS transistors. The cross-coupled MOS transistors are configured to provide negative resistance for the main resonant circuit.

With reference to the second aspect, in some possible implementations, the differential oscillator further includes: a power line, disposed on a chip; a ground line, disposed on the chip and parallel to the power line; the main resonant circuit, where the main resonant circuit further includes a second inductor, the first inductor and the second inductor are disposed on a side that is of the power line and that is far away from the ground line, and the main resonant circuit is connected to the power line; and a tail resonant circuit, disposed on the chip.

With reference to the second aspect, in some possible implementations, the tail resonant circuit includes a tail inductor. The tail inductor includes a tail inductor body and a tail inductor connection portion. The tail inductor body is disposed on a side that is of the ground line and that is far away from the power line. The tail inductor connection portion is configured to connect to the tail inductor body and the main resonant circuit.

With reference to the second aspect, in some possible implementations, a distance between the ground line and the power line is less than or equal to a first preset value.

With reference to the second aspect, in some possible implementations, the differential oscillator further includes a decoupling capacitor. The decoupling capacitor is disposed between the ground line and the power line, and is connected to the power line and the ground line.

With reference to the second aspect, in some possible implementations, the tail inductor connection portion is disposed in parallel with the ground line, and the tail inductor connection portion is located between the tail inductor body and the ground line.

According to a third aspect, a chip is provided, including the differential oscillator described above.

## BRIEF DESCRIPTION OF DRAWINGS

FIG. 1 is a schematic diagram of a circuit structure of a differential oscillator using a tail inductor resonance technology;

FIG. 2 is a schematic diagram of a parasitic parameter of a circuit structure of a differential oscillator using a tail inductor resonance technology;

FIG. 3 is a schematic diagram of a circuit structure and a layout of a differential oscillator according to an embodiment of this application;

FIG. 4 is a schematic diagram of a circuit structure and a layout of a differential oscillator according to another embodiment of this application;

FIG. 5 is a schematic diagram of an alternating current equivalent circuit of a tail resonant network of a differential oscillator using a tail inductor resonance technology;

FIG. 6 is another schematic diagram of an alternating current equivalent circuit of a tail resonant network of a differential oscillator using a tail inductor resonance technology;

FIG. 7 is yet another schematic diagram of an alternating current equivalent circuit of a tail resonant network of a differential oscillator using a tail inductor resonance technology;

FIG. 8 is a schematic circuit diagram of an adjustable capacitor of a differential oscillator;

FIG. 9 is a schematic circuit diagram of an adjustable capacitor according to an embodiment of this application;

FIG. 10 is a schematic circuit diagram of an adjustable capacitor according to another embodiment of this application;

FIG. 11 is a schematic diagram of a relationship between a gate voltage and a gate capacitance of a MOS transistor;

FIG. 12 is a schematic diagram of another relationship between a gate voltage and a gate capacitance of a MOS transistor;

FIG. 13 is a schematic diagram of a circuit structure and a layout of a differential oscillator according to yet another embodiment of this application;

FIG. 14 is a schematic circuit diagram of an adjustable capacitor used in a differential oscillator; and

FIG. 15 is a schematic diagram of a test result of a differential oscillator according to an embodiment of this application.

## DESCRIPTION OF EMBODIMENTS

The following describes technical solutions of this application with reference to accompanying drawings.

A clock is an important component of a communication system. Main functions of the clock include: (1) working with a frequency mixer to perform signal up-conversion and signal down-conversion; and (2) providing a sampling clock for an analog-to-digital converter (analog-to-digital converter, ADC) and a digital-to-analog converter (digital-to-analog converter, DAC), to perform conversion between a digital signal and an analog signal. An oscillator is a core part for implementing a high-quality clock. Both high-quality communication and a high-precision ADC/DAC have a strict requirement for a high-performance oscillator. The oscillator may be a voltage controlled oscillator (voltage controlled oscillator, VCO), a digitally controlled oscillator (digitally controlled oscillator, DCO), or the like. The oscillator implementing a high-quality clock is essential for a high-precision communication system.

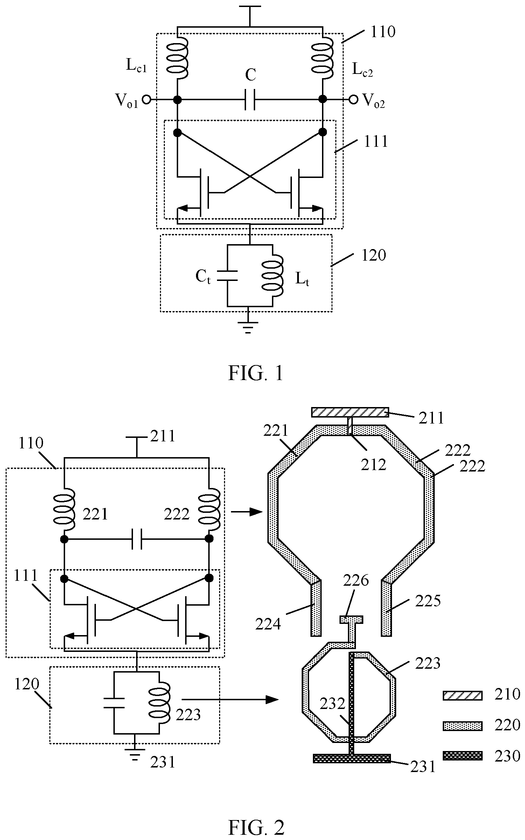

FIG. 1 is a schematic diagram of a circuit structure of a conventional differential oscillator using a tail inductor resonance technology.

A circuit of the differential oscillator using the tail inductor resonance technology includes a main resonant circuit 110 and a tail resonant circuit 120. The main resonant circuit 110 includes a negative resistor 111. The negative resistor 111 includes cross-coupled metal-oxide-semiconductor (metal-oxide-semiconductor, MOS) field effect transistors (field effect transistor, FET). The MOSFET is also referred to as a MOS transistor, or a MOS device. The main resonant circuit 110 may include a first capacitor C, and a first inductor $L_{c1}$ and a second inductor $L_{c2}$ that have a same inductance. The tail resonant circuit 120 may include a tail inductor $L_t$ and a tail capacitor $C_t$.

The cross-coupled MOS transistors are equivalent to a linear negative resistor, and provide energy to the main resonant circuit 110, to compensate for a loss of the main resonant circuit 110 and maintain oscillation.

When a process variation is not considered, the main resonant circuit 110 may be considered as two parts with symmetrical structures. $L_{c1} = L_{c2}$, $C = C_{c1} // C_{c2}$, and $C_{c1} = C_{c2}$. A voltage at a connection between $C_{c1}$ and $C_{c2}$ may be considered as a ground of an alternating current signal. That is, the voltage at the connection between $C_{c1}$ and $C_{c2}$ is 0 for the alternating current signal. One resonant circuit includes $L_{c1}$ and $C_{c1}$, and the other resonant circuit includes $L_{c2}$ and $C_{c2}$. Resonance frequencies of the two resonant circuits are equal. The resonance frequency may be referred to as an oscillation frequency of the main resonant circuit 110. For the alternating current signal, one terminal of $L_{c1}$ and one terminal of $C_{c1}$ are grounded, and the other terminal of $L_{c1}$ and the other terminal of $C_{c1}$ are an output voltage $V_{o1}$; and one terminal of $L_{c2}$ and one terminal of $C_{c2}$ are grounded, and the other terminal of $L_{c2}$ and the other terminal of $C_{c2}$ are an output voltage $V_{o2}$. At $V_{o1}$ and $V_{o2}$, direct current voltages are equal, amplitudes of alternating current voltages are equal, and phases of the alternating current voltages are opposite.

The tail resonant circuit 120 may include the tail inductor and the capacitor. An oscillation frequency of the tail resonant circuit 120 is twice the oscillation frequency of the main resonant circuit 110. When the oscillation frequency of the tail resonant circuit 120 deviates from the double of the oscillation frequency of the main resonant circuit 110, a phase noise of the oscillator increases as a difference between the oscillation frequency of the tail resonant circuit 120 and the double of the oscillation frequency of the main resonant circuit 110 increases.

FIG. 2 is a schematic diagram of a circuit layout of a conventional differential oscillator using a tail inductor resonance technology.

In the circuit layout of the conventional differential oscillator using the tail inductor resonance technology, a part 210 connected to a power supply includes a power line 211 and a power line connection portion 212. The power line connection portion 212 may be configured to connect the power line 211 to another component of the differential oscillator.

An inductor 220 includes a first inductor, a second inductor, and a tail inductor. The first inductor includes a first inductor body 221 and a first inductor connection portion 224. The second inductor includes a second inductor body 222 and a second inductor connection portion 225. The tail inductor includes a tail inductor body 223 and a first tail inductor connection portion 226. The first inductor connection portion 224 may be configured to connect to a first MOS transistor. The second inductor connection portion 225 may be configured to connect to a second MOS transistor. The first tail inductor connection portion 226 may be configured to connect to the tail inductor body 223 and a tail capacitor. The first tail inductor connection portion 226 may be further configured to connect the tail inductor body 223 to the first MOS transistor and the second MOS transistor. The tail inductor may further include a second tail inductor connection portion 227, configured to connect to the tail inductor body 223 and the first tail inductor connection portion 226. The first tail inductor connection portion 226 may be connected to the tail inductor body 223 and the tail capacitor by using the second tail inductor connection portion 227.

A part 230 connected to a ground includes a ground line 231 and a ground line connection portion 232. The ground line connection portion 232 may be configured to connect the ground line 231 to another component of the differential oscillator. For example, the ground line connection portion 232 may be configured to connect the ground line 231 to the tail inductor body 223 and connect the ground line 231 to the tail capacitor.

Devices such as the first inductor body 221, the second inductor 222, the tail inductor body 223, a capacitor, and the MOS transistors are disposed between the power line 211 and the ground line 231. There is a comparatively large distance between the power line 211 and the ground line 231. The power line 211 is connected to the first inductor body 221 and the second inductor 222 by using the power line supply connection portion 212. The ground line 231 is connected to the tail inductor body 223 by using the ground connection portion 232. To reduce an alternating current impedance between the power line and the ground line, a quite large decoupling capacitor needs to be disposed around the circuit. The comparatively large decoupling capacitor occupies a comparatively large area and wastes chip resources. In addition, due to a parasitic effect, it is difficult to ensure that both voltages on the power line and the ground line are 0 for the alternating current signal. In other words, it cannot be ensured that both the power line and the ground line are a virtual "ground". "Disposed" may also be understood as "disposed", "placed", "configured", or the like, may indicate that a part/component is located on a chip, or may indicate a positional relationship between parts/components.

The tail resonant circuit 120 may include the tail inductor body 223 and the tail capacitor. When the oscillation frequency of the tail resonant circuit 120 is twice the oscillation frequency of the main resonant circuit 110, the phase noise is minimum. When it cannot be ensured that both the power line and the ground line are a virtual "ground", the tail resonant circuit 120 in the circuit cannot be precisely designed, and a comparatively large phase noise is generated.

To resolve the foregoing problem, this application provides a differential oscillator. A precise parasitic parameter of the oscillator can be obtained. This reduces the phase noise of the oscillator through proper design.

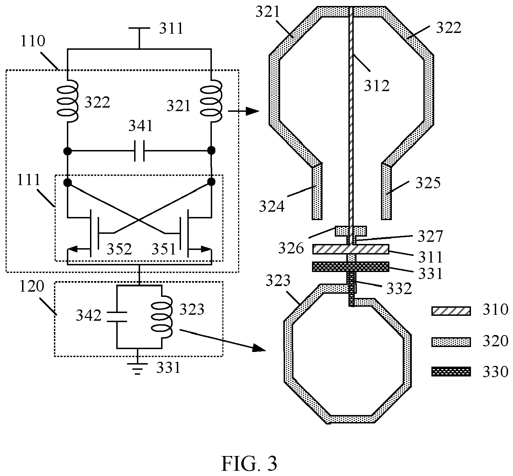

FIG. 3 is a schematic diagram of a circuit structure and a layout of a differential oscillator according to an embodiment of this application.

The differential oscillator includes a power line 311, a ground line 331, a main resonant circuit 110, and a tail resonant circuit 120. In this embodiment of this application, the oscillator is a differential oscillator.

The differential oscillator is located on a chip.

The power line 311 is disposed on the chip.

The ground line 331 is disposed on the chip and is parallel to the power line 311. That the ground line 331 is parallel to the power line 311 may be understood as that the ground line 331 is approximately parallel to the power line 311.

The main resonant circuit 110 is disposed on the chip and includes a first inductor 321 and a second inductor 322. The main resonant circuit 110 is connected to the power line 311.

The tail resonant circuit 120 is disposed on the chip. The tail resonant circuit 120 is connected to the main resonant circuit and the ground line.

It should be understood that a "connection" in this application indicates an electrical connection. That A and B are connected means that A and B are electrically connected. To be specific, A and B may be connected by using an interconnection line, or another part/component is connected between A and B, for example, A is connected to B by using C. Parts/Components in the chip are connected by using an interconnection line. The interconnection line may also be referred to as a conducting wire, an interconnection conducting wire, a metallic wire, or the like.

The tail resonant circuit 120 includes a tail inductor and a tail capacitor 342. The tail inductor includes a tail inductor body 323 and a tail inductor connection portion 326. The tail inductor connection portion 326 is configured to connect to the tail inductor body 323 and the tail capacitor.

The tail inductor connection portion 326 may be further configured to connect to the tail inductor body 323 and the main resonant circuit.

It may be understood that the power line 311 and the ground line 331 divide a chip region in which the differential oscillator is located into the following parts: a first part that is located between the power line and the ground line, and a second part and a third part that are separately located on two sides of the power line 311 and the ground line 331.

In a possible implementation, the first inductor and the second inductor may be located in the second part. The tail inductor body 323 may be located in the second part or the third part. When the tail inductor body 323 is located in the third part, a distance between the power line 311 and the ground line 331 can be further reduced. In other words, the power line 311 and the ground line 331 approximate a virtual "ground". The following provides a description by using an example in which the tail inductor body 323 is disposed on a side that is of the ground line and that is far away from the power line In other words, the tail inductor body 323 is located in the third part.

The second part may be a side far away from the power line 311, and the third part may be a side far away from the ground line 331. Alternatively, the third part may be a side far away from the power line 311, and the second part may be a side far away from the ground line 331. The following provides a description by using an example in which the second part is the side far away from the ground line 331, and the third part is the side far away from the power line 311, in other words, as shown in FIG. 3, a case in which the first inductor 321 and the second inductor 322 are disposed on the side that is of the power line 311 and that is far away from the ground line 331, and the tail inductor body 323 is disposed on the side that is of the ground line and that is far away from the power line.

When the first inductor 321, the second inductor 322, and the tail inductor body 323 are separately located on the two sides of the ground line 331 and the power line 311, the distance between the ground line 331 and the power line 311 may be quite small, and a comparatively large capacitance is generated.

For an alternating current signal, when an impedance between the ground line 331 and the power line 311 is comparatively small, it can be ensured that both the ground line 331 and the power line 311 are a virtual "ground".

When the distance between the ground line 331 and the power line 311 is quite small, a parasitic parameter generated by a decoupling capacitor disposed between the power line 311 and the ground line 331 is comparatively small, and the ground line 331 and the power line 311 approximate a virtual "ground". When the distance between the ground line 331 and the power line 311 is quite small, a requirement of the differential oscillator for the decoupling capacitor is reduced. Disposing a comparatively small decoupling capacitor between the ground line 331 and the power line 311 can meet a circuit design requirement. The comparatively small decoupling capacitor occupies a comparatively small area, and reduces occupied chip resources.

Many of devices in the differential oscillator are connected to the ground line 331 or the power line 311. For example, a capacitor and the inductors in the main resonant circuit, the capacitor and the inductor in the tail resonant circuit, and bulks of cross-coupled MOS devices are connected to the ground line 331 or the power line 311. When the ground line 331 and the power line 311 are close to be a virtual "ground", a parasitic parameter of a part/component that is in the differential oscillator and that is connected to the ground line 331 or the power line 311 can be determined more accurately. A difference between an oscillation frequency of the tail resonant circuit and the double of an oscillation frequency of the main resonant circuit 110 can be reduced through proper design. This reduces a phase noise of the oscillator.

Optionally, the distance between the ground line 331 and the power line 311 is less than or equal to a first preset value. The distance between the ground line 331 and the power line 311 may also be understood as a width of the first part.

Optionally, the differential oscillator may include a decoupling capacitor. The decoupling capacitor is configured to increase a capacitance between the power line 311 and the ground line 331, to reduce an impedance between the power line 311 and the ground line 331 relative to an alternating current signal. Two terminals of the decoupling capacitor are separately connected to the power line 311 and the ground line 331. When the decoupling capacitor is disposed, the alternating current impedance between the power line 311 and the ground line 331 can be reduced, and the power line 311 and the ground line 331 approximate a virtual "ground".

A location of the decoupling capacitor is not limited in this embodiment of this application. The decoupling capacitor may be disposed, for example, in the first part, the second part, or the third part. The decoupling capacitor may be a metal-oxide-metal (metal-oxide-metal, MOM) capacitor, a metal-insulator-metal (metal-insulator-metal, MIM) capacitor, a polysilicon-insulator-polysilicon (polysilicon-insulator-polysilicon, PIP) capacitor, or the like. When the decoupling capacitor is a MOM capacitor, an area occupied by the capacitor can be reduced. When the decoupling capacitor is disposed between the ground line and the power line, in other words, the decoupling capacitor is disposed in the first part, it is easy to implement in a process, a parasitic effect is reduced, and an occupied chip area can be reduced.

A comparatively large capacitance is generated between the power line 311 and the ground line 331 that are disposed adjacently, and a requirement for the decoupling capacitor is reduced. Therefore, when a comparatively small decoupling capacitor is disposed around the power line and the ground line, the alternating current impedance between the power line 311 and the ground line 331 can meet a circuit design requirement.

The tail capacitor may be a MOM capacitor, a MIM capacitor, a PIP capacitor, or the like.

Optionally, the tail inductor connection portion 326 is disposed in parallel with the ground line 331. "Parallel" may be "approximately parallel". Arranging the tail inductor connection portion 326 and the ground line 331 in parallel reduces difficulty in implementing the tail capacitor in a process. The tail inductor connection portion 326 may be located in the first part, the second part, or the third part. When the tail inductor connection portion 326 is located in a part that is in the third part and that is between the tail inductor body 323 and the ground line, difficulty in implementing the tail capacitor in the process can be reduced, and an area occupied by the tail capacitor can be reduced.

The main resonant circuit in the differential oscillator further includes cross-coupled MOS devices. A first MOS transistor 351 and a second MOS transistor 352 that are cross-connected in a coupling manner may serve as a negative resistor of the differential oscillator. Process parameters of the first MOS transistor 351 and the second MOS transistor 352 are the same. The cross-coupled MOS transistors may be equivalent to a linear negative resistor. The cross-coupled MOS transistors may provide energy to the main resonant circuit 110, to compensate for a loss of the main resonant circuit 110 and maintain oscillation.

The MOS device is a four-terminal device, including a source (source), a drain (drain), a gate (gate), and a bulk (bulk). Both the first MOS transistor 351 and the second MOS transistor 352 may be N-channel MOS (N-channel MOS, NMOS) transistors or P-channel MOS (P-channel MOS, PMOS) transistors. A bulk of the NMOS transistor is connected to a low potential of the chip, in other words, connected to a "ground". The bulk of the NMOS transistor may be connected to the ground line 331. A bulk of the PMOS transistor is connected to a high potential, in other words, connected to a supply voltage. The bulk of the PMOS transistor may be connected to the power line 311. As shown in FIG. 3, if the first MOS transistor 351 and the second MOS transistor 352 are NMOS transistors, sources of the first MOS transistor 351 and the second MOS transistor 352 are connected to the tail resonant circuit; bulks of the first MOS transistor 351 and the second MOS transistor 352 are grounded, in other words, the bulks are connected to the ground line 331; drains of the first MOS transistor 351 and the second MOS transistor 352 are separately connected to the first inductor 321 and the second inductor 322 in the main resonant circuit; and a gate of the first MOS transistor 351 is connected to the drain of the second MOS transistor 352, and a gate of the second MOS transistor 352 is connected to the drain of the first MOS transistor 351. If the first MOS transistor 351 and the second MOS transistor 352 are PMOS transistors, bulks of the first MOS transistor 351 and the second MOS transistor 352 are connected to the supply voltage, in other words, connected to the power line 311; sources of the first MOS transistor 351 and the second MOS transistor 352 are connected to the power line 311; drains of the first MOS transistor 351 and the second MOS transistor 352 are separately connected to the first inductor 321 and the second inductor 322 in the main resonant circuit; and a gate of the first MOS transistor 351 is connected to the drain of the second MOS transistor 352, and a gate of the second MOS transistor 352 is connected to the drain of the first MOS transistor 351.

Parasitic capacitors of the MOS device include: a drain-bulk capacitor $C_{db}$ between the drain and the bulk, a gate-source capacitor $C_{gs}$ between the gate and the source, a gate-drain capacitor $C_{gd}$ between the gate and the source, a source-bulk capacitor $C_{sb}$ between the source and the bulk, and the like.

The differential oscillator may further include a first inductor connection portion 324, a second inductor connection portion 325, and the tail inductor connection portion 326. The first inductor connection portion 324 may be configured to connect the first inductor 321 to another component, for example, to connect the first inductor 321 to the first MOS transistor 351. The second inductor connection portion 325 may be configured to connect the second inductor 322 to another component, for example, to connect the second inductor 322 to the second MOS transistor 352.

An inductor component 310 may include the first inductor 321, the second inductor 322, the tail inductor body 323, the first inductor connection portion 324, the second inductor connection portion 325, and the tail inductor connection portion 326. The inductor component 310 may be located at a same metal layer or different metal layers. Each component in the inductor component 320 may also be located at a same metal layer or different metal layers. For example, one part of metal in the tail inductor body 323 may be located at a same metal layer as a ground line connection portion 332, and another part of metal in the tail inductor body 323 may be located at a metal layer different from the metal layer at which the ground line connection portion 332 is located.

The tail inductor may further include a connection portion 327, configured to connect to the tail inductor body 323 and the tail inductor connection portion 326.

Locations of the first inductor connection portion 324, the second inductor connection portion 325, and the tail inductor connection portion 326 are not limited in this embodiment of this application. The first inductor connection portion 324 is used as an example. The first inductor connection portion 324 may be located in the second part. In this case, the first inductor connection portion 324 may be located at a same metal layer as a power supply component 310 and the first inductor 321, or may be located at a metal layer different from the metal layer at which the power supply component 310 and the first inductor 321 are located. One part of the first inductor connection portion 324 may be located in the second part, and another part of the first inductor connection portion 324 may be located in the first part. In this case, the first inductor connection portion 324 may be located at a metal layer different from a metal layer at which the power line 311 is located.

The power supply component 310 may include the power line 311 and a power line connection portion 312. The power supply component 310 may be located at a same metal layer or different metal layers.

The ground line component 330 may include the ground line 331 and the ground line connection portion 332. The ground line component 330 may be located at a same metal layer or different metal layers.

The power supply component 310 and the ground line component 330 may be disposed at a same metal layer or different metal layers. Considering that a wire width of a metallic wire is less than a thickness of a metal layer, when the power line 311 and the ground line 331 are located at a same metal layer, and a width W of the first part is the same, an actual distance between the power line 311 and the ground line 331 can be reduced, thereby increasing a parasitic capacitance between the power line 311 and the ground line 331.

When the power supply component 310, the ground line component 330, the first inductor 321, the second inductor 322, and the tail inductor body 323 are located at a same metal layer, a quantity of metal layers in the oscillator can be reduced. This reduces a parasitic parameter resulting from interconnection and reduces manufacturing costs. If possible, the power supply component 310, the ground line component 330, and the inductor component 310 may be located at a same metal layer.

Inductances of the first inductor 321 and the second inductor 332 in the main resonant circuit 110 are equal. The first inductor 321 and the second inductor 332 may be disposed symmetrically. The first inductor 321 and the second inductor 332 may be separately disposed in a surrounding shape such as an octagon or a hexagon.

Alternatively, the first inductor 321 and the second inductor 332 may jointly form a surrounding shape such as an octagon or a hexagon. For each of the first inductor 321 and the second inductor 332, a position at which the inductor is connected to the power line connection portion 312 may be one terminal of the inductor, and a position at which the inductor is connected to the cross-coupled MOS devices may be the other terminal of the inductor.

The main resonant circuit 110 includes a first capacitor 341. The first capacitor 341 may be an adjustable capacitor. When the first capacitor 341 may be an adjustable capacitor, a VCO/DCO can be implemented. A structure of the adjustable capacitor is not limited in this embodiment of this application. Various capacitor structures that are available or that may occur in the future may be used. The following provides a detailed description with reference to a specific embodiment, and details are not described herein.

The first capacitor 341 may include a fixed capacitor. The fixed capacitor may be a MOM capacitor, a MIM capacitor, a PIP capacitor, or the like. A location of the first capacitor 341 is not limited in this embodiment of this application. The first capacitor 341 may be located at any position on the chip.

Optionally, the fixed capacitor in the first capacitor may be located in the second part. The fixed capacitor may be a MOM capacitor. A metallic wire constituting the first capacitor may be disposed in parallel with the power line 311. When the fixed capacitor uses the foregoing layout manner, utilization of the chip area can be improved.

For the first inductor, the second inductor, and the tail inductor, refer to a single-coil inductor shown in FIG. 2 and FIG. 3. That is, a metallic wire constituting the first inductor and the second inductor may be wound into approximately one coil, and a metallic wire constituting the tail inductor may be disposed as being wound into approximately one coil.

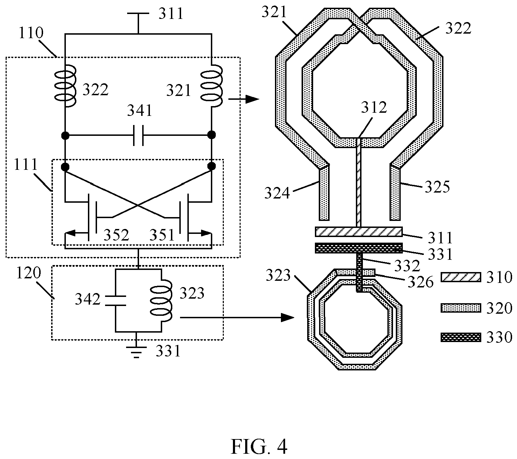

FIG. 4 is a schematic diagram of a circuit structure and a layout of a differential oscillator according to an embodiment of this application.

Alternatively, a first inductor, a second inductor, and a tail inductor may be two-coil inductors or multi-coil inductors. That is, a metallic wire constituting the first inductor and the second inductor may be wound into approximately two or more coils, and a metallic wire constituting the tail inductor may be wound into approximately two or more coils.

Compared with a single-coil inductor, the first inductor and the second inductor that are two-coil inductors or multi-coil inductors have a lower common-mode inductance. According to an expression of a common-mode resonance component $F_c$, a reduction in a common-mode inductance can weaken a relationship between the common-mode resonance component $F_c$ and a frequency, thereby facilitating design of the differential oscillator.

A tail inductor connection portion 326 is disposed in parallel with a ground line 331. "Parallel" may be "approximately parallel". Arranging tail the inductor connection portion 326 and the ground line 331 in parallel reduces difficulty in implementing a tail capacitor in a process. The tail inductor connection portion 326 may be located in a part that is in a third part and that is between the tail inductor and the ground line. In this way, difficulty in implementing the tail capacitor in the process can be reduced, and an area occupied by the tail capacitor can be reduced.

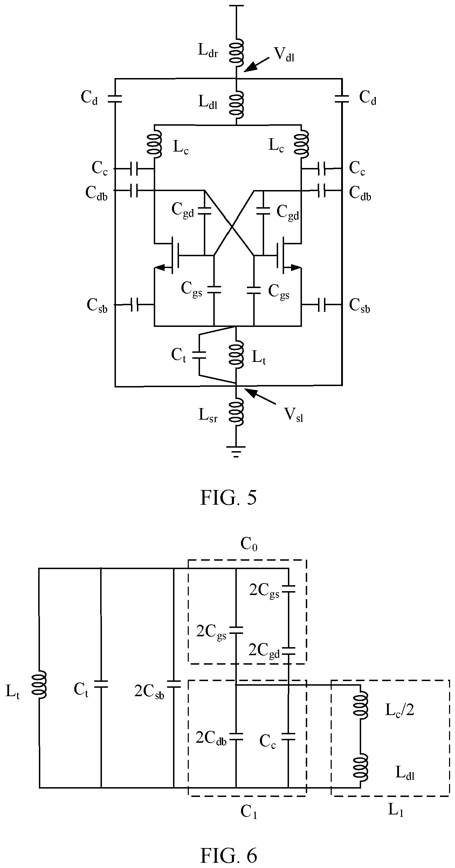

FIG. 5 is a schematic diagram of a parasitic parameter of a circuit structure of a differential oscillator using a tail inductor resonance technology.

For the differential oscillators using the tail inductor resonance technology in FIG. 2, FIG. 3, and FIG. 4, a large quantity of parasitic parameters are generated in an actually produced circuit due to impact of a manufacturing process.

In the circuit structure of the differential oscillator, a power line voltage of the differential oscillator may be represented by $V_{dl}$, and a ground voltage of the differential oscillator may be represented by $V_{sl}$. An inductor between a power line of the differential oscillator and a power supply module may be represented by $L_{dr}$, and an inductor between a ground line of the differential oscillator and a ground of a chip is represented by $L_{sr}$. A parasitic inductor of the power line and an inductor lead-out terminal of the oscillator is represented by $L_{dl}$. $L_c$ represents a common-mode component of a resonant inductor of the differential oscillator, and may represent inductances of the inductors $L_{c1}$ and $L_{c2}$ in FIG. 1. In other words, $L_{c1} = L_{c2} = L_c$. $C_c$ represents a common-mode component of a resonant capacitor of the differential oscillator, and may represent one-half of a capacitance of the capacitor C in FIG. 1. $C_d$ represents a decoupling capacitor (decoupling capacitor, decap), where the decoupling capacitor is a coupling capacitor between a power supply of a circuit and a ground of the circuit. A tail capacitor $C_t$ and a tail inductor $L_t$ are a tuning part of a tail resonant network. The power supply module provides electrical energy to the power line of the differential oscillator. An output of the power supply module may be used as a supply voltage of the power line of the differential oscillator. That is, an output terminal of the power supply module may be connected to the power line of the differential oscillator by using an interconnection conducting wire. Alternatively, the output terminal of the power supply module may be connected to the power line of the differential oscillator by using a DC-DC converter, a low dropout linear regulator (low dropout regulator, LDO), or the like.

Parasitic parameters of cross-coupled MOS transistors that serve as a negative resistor have comparatively large impact on performance of the differential oscillator.

Parasitic parameters between the power line and the ground line can be precisely determined by using the circuit layout of the differential oscillator in FIG. 3. The plurality of parasitic parameters of the MOS transistors are connected to the power line and the ground line. The parasitic parameters of the cross-coupled MOS transistors in the differential oscillator can be precisely determined through precise determining of the parasitic parameters between the power line and the ground line. Therefore, a difference between an oscillation frequency of a tail resonant circuit and the double of an oscillation frequency of a main resonant circuit can be reduced through proper design. This reduces a phase noise of the oscillator.

In the differential oscillator using the tail inductor resonance technology, the tail inductor and the tail capacitor resonate at an oscillation frequency twice the oscillation frequency of the main resonant circuit. This implements a function of the oscillator. When the oscillation frequency of the tail inductor and the tail capacitor is closer to twice the oscillation frequency of the main resonant circuit, the phase noise of the oscillator is smaller. Impact of the parasitic parameters on the performance of the oscillator is analyzed below.

FIG. 6 is a schematic diagram of an alternating current equivalent circuit of a tail resonant network of a conventional differential oscillator using a tail inductor resonance technology. $C_{sb}$ represents a parasitic capacitor between a source and a bulk of the cross-coupled negative-resistance MOS device, $C_{gs}$ represents a parasitic capacitor between a gate and a source of the MOS device, $C_{gd}$ represents a parasitic capacitor between the gate and the drain of the MOS device, and $C_{db}$ represents a parasitic capacitor between the drain and the bulk of the MOS device. $C_0$ represents a capacitance obtained when the two parasitic capacitors $C_{gs}$ and the two parasitic capacitors $C_{gd}$ are connected in series and then connected to the two parasitic capacitors $C_{gs}$ in parallel. $C_1$ represents a capacitance obtained when the two parasitic capacitors $C_{db}$ are connected to the two capacitors $C_c$ in parallel. $L_1$ represents an inductance obtained when $L_c/2$ and $L_{d1}$ are connected in series. The alternating current equivalent circuit of the tail resonant network may be shown by using a circuit structure in FIG. 6.

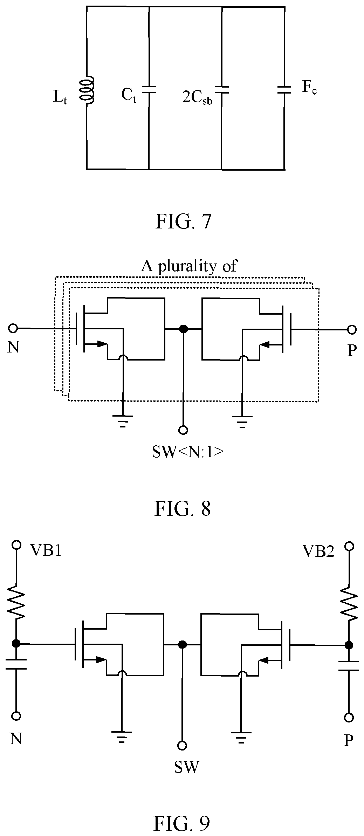

FIG. 7 is a schematic diagram of an alternating current equivalent circuit of a tail resonant network of a differential oscillator using a tail inductor resonance technology. FIG. 5 shows a simplified structure of the alternating current equivalent circuits in FIG. 3 and FIG. 4. FIG. 6 shows a structure obtained after the structure in FIG. 5 is further simplified. The tail resonant network includes a tail resonant inductor $L_t$, the tail capacitor $C_t$, the parasitic capacitor $C_{sb}$, and a common-mode resonance component $F_c$ that are connected in parallel. The common-mode resonance component $F_c$ may represent an impedance obtained when $L_1$ and $C_1$ are connected in parallel and then connected to $C_0$ in series. The common-mode resonance component $F_c$ may be expressed by using the parameters in FIG. 6. That is, the common-mode resonance component $F_c$ may be expressed as follows:

$$ F_c = C_0 * \frac{1 - \omega^2 L_1 C_1}{1 - \omega^2 L_1 (C_1 + C_0)} = C_0 * \frac{1 - a(\omega)}{1 - b(\omega)} $$

In the tail inductor resonance technology, when the tail inductor and the tail capacitor resonate at an oscillation frequency twice the oscillation frequency of the main resonant circuit, the phase noise is the minimum. To precisely design and determine a resonant inductor $L_t$ of the tail inductor and the tail capacitor $C_t$, the parasitic parameters such as $C_{db}$, $C_{gs}$, $C_{gd}$, $L_{dl}$, $L_c$, $C_{sb}$, and $C_c$ need to be first determined. These parasitic parameters are connected to a virtual "ground". Therefore, precise parameters between the power supply and the ground are required.

In the differential oscillator provided in this embodiment of this application, the inductors in the main resonant circuit and the tail inductor in the tail resonant circuit are separately located on the two sides of the power line and the ground line. Therefore, the distance between the power line and the ground line is reduced, and it can be precisely determined that the parameters between the power line and the ground line are comparatively small. To be specific, it is ensured that the parasitic parameters such as $C_{db}$, $C_{gs}$, $C_{gd}$, $L_{dl}$, $L_c$, $C_{sb}$, and $C_c$ are connected to the virtual "ground", and these parasitic parameters are precisely determined. Therefore, when the resonant inductor $L_t$ and the tail capacitor $C_t$ are properly designed, the phase noise of the oscillator can be reduced.

FIG. 8 is a schematic circuit diagram of an adjustable capacitor used in a main resonant circuit of a differential oscillator.

For a circuit structure of the differential oscillator, refer to FIG. 1 to FIG. 4. For a layout of the differential oscillator, refer to FIG. 2 to FIG. 4. The differential oscillator may include the main resonant circuit, cross-coupled MOS transistors, and a tail circuit. A structure of the tail circuit is not specifically limited in this embodiment of this application. For the tail circuit, refer to the tail resonant circuit in FIG. 1. The tail circuit may alternatively use a constant current source or another circuit structure.

For the differential oscillator using the adjustable capacitor, an oscillation frequency can be adjusted, so that the oscillator is applicable to a wider frequency range. However, a comparatively large phase noise is introduced if the adjustable capacitor is used.

The adjustable capacitor used in the main resonant circuit of the differential oscillator is a capacitor array including a plurality of capacitor units. For example, the adjustable capacitor is a capacitor array including N capacitor units, where N is a positive integer greater than or equal to 1. Each capacitor unit in the capacitor array includes two MOS varactors (varactors). Process parameters of the two MOS varactors are the same. The MOS varactors may constitute a voltage controlled capacitor. It may be understood that: That process parameters of the two MOS varactors are the same includes that the process parameters of the two MOS varactors are approximately the same. Bulks of the two MOS varactors are connected to a same potential. Both a source and a drain of each of the two MOS varactors are connected to a same potential in parallel, and the potentials at the sources and the drains of the two MOS varactors are controlled by a control voltage. The two MOS varactors may be disposed symmetrically. Gate capacitors of a first MOS varactor and a second MOS varactor are connected to the circuit, to form a part of the adjustable capacitor in the main resonant circuit.

Gates of the two MOS varactors are separately connected to a point N and a point P. The point N and the point P are separately two output terminals of the differential oscillator. For example, in the differential oscillator using the tail inductor resonance technology shown in FIG. 1, the point N and the point P may be $V_{o1}$ and $V_{o2}$, respectively. The point N and the point P are separately connected to the gates of the two MOS varactors. Both the sources and the drains of the two MOS varactors are controlled by a switching voltage.

In this embodiment of this application, the control voltage may be represented by a switch (switch, SW). The control voltage may also be referred to as the switching voltage. SW = 1 and SW = 0 may be used to represent two voltage value states of the control voltage. One voltage value state indicates that the control voltage is at a high level, and the other voltage value state indicates that the control voltage is at a low level. As a voltage controlled device, a MOS varactor has different capacitances under two biases of the switching voltage SW = 1 and SW = 0. Therefore, the MOS varactor can be configured to adjust a resonance frequency of the main resonant circuit of the oscillator.

Both the two MOS varactors may be N-channel MOS (N-channel MOS, NMOS) transistors or P-channel MOS (P-channel MOS, PMOS) transistors.

A signal output by each output terminal of the differential oscillator includes a direct current signal and an alternating current signal. A capacitance of a MOS varactor is related to a gate voltage of the MOS varactor.

A gate voltage of a MOS varactor is a voltage at a gate of the MOS varactor. The gate of the MOS varactor is connected to the output terminal of the oscillator, a power supply noise may affect a voltage at the output terminal of the oscillator, and the voltage at the output terminal of the oscillator is a gate voltage of the MOS varactor. As the voltage at the output terminal of the oscillator changes, a capacitance of the adjustable capacitor used in the main resonant circuit of the differential oscillator changes. Therefore, the power supply noise may cause a change in a capacitance of the MOS varactor, resulting in a comparatively large phase noise of the differential oscillator.

To resolve the foregoing problem, this application provides a differential oscillator, where an adjustable capacitor is improved. The differential oscillator includes a main resonant circuit and cross-coupled MOS transistors. The main resonant circuit includes a first capacitor.

The first capacitor includes a first fixed capacitor, a first MOS varactor, a second MOS varactor, and a second fixed capacitor that are connected in series. The first fixed capacitor is connected to a gate of the first MOS varactor, and the second fixed capacitor is connected to a gate of the second MOS varactor. A control voltage is a bias voltage of a source and a drain of the first MOS varactor and a bias voltage of a source and a drain of the second MOS varactor. A first bias voltage VB 1 provides a direct current bias for the gate of the first MOS varactor, and a second bias voltage VB2 provides a direct current bias for the gate of the second MOS varactor. A sum of a capacitance of the first fixed capacitor and a capacitance of the first MOS varactor is equal to a sum of a capacitance of the second MOS varactor and a capacitance of the second fixed capacitor. The first bias voltage and the second bias voltage are bias voltages obtained from a supply voltage provided by a power line.

It should be understood that: That the first bias voltage and the second bias voltage are bias voltages obtained from a supply voltage provided by a power line means that all of the first bias voltage, the second bias voltage, and the power line are provided with electrical energy by a power supply module in the chip. The first bias voltage and the second bias voltage may be obtained through conversion of the supply voltage provided by the power line, or may be obtained through conversion of a voltage at a point between the power supply module and the power line. The point between the power supply module and the power line may be a point on an interconnection line between the power supply module and the power line, or a point on a part/component between the power supply module and the power line.

The first fixed capacitor is connected to the gate of the first MOS varactor, and the second fixed capacitor is connected to the gate of the second MOS varactor. The control voltage is the bias voltage of the source and the drain of the first MOS varactor and the bias voltage of the source and the drain of the second MOS varactor. The first bias voltage provides the direct current bias for the gate of the first MOS varactor, and the second bias voltage provides the direct current bias for the gate of the second MOS varactor.

The fixed capacitors and the MOS varactors are connected in series to implement voltage division. In this way, a change in a gate voltage of the MOS varactor caused by a power supply noise can be reduced. Therefore, a phase noise of the differential oscillator can be reduced.

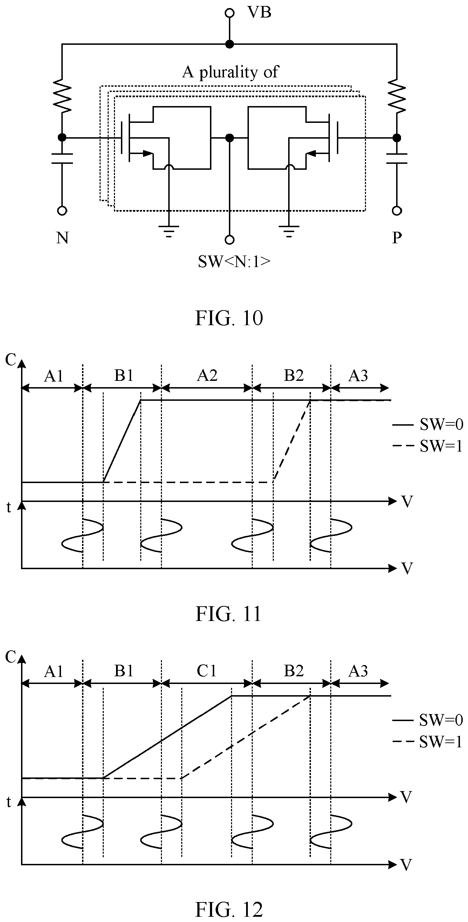

For a structure of the first capacitor, refer to FIG. 9 and FIG. 10.

FIG. 9 is a schematic structural diagram of a capacitor used in a differential oscillator according to an embodiment of this application.

The capacitor used in the differential oscillator includes a main resonant circuit that is disposed on a chip. The main resonant circuit includes a first fixed capacitor, a first MOS varactor, a second MOS varactor, and a second fixed capacitor.

The first fixed capacitor is connected to a gate of the first MOS varactor, and the second fixed capacitor is connected to a gate of the second MOS varactor. A control voltage is a bias voltage of a source and a drain of the first MOS varactor and a bias voltage of a source and a drain of the second MOS varactor. A first bias voltage VB1 provides a direct current bias for the gate of the first MOS varactor, and a second bias voltage VB2 provides a direct current bias for the gate of the second MOS varactor. A sum of a capacitance of the first fixed capacitor and a capacitance of the first MOS varactor is equal to a sum of a capacitance of the second MOS varactor and a capacitance of the second fixed capacitor.

Gate capacitors of the first MOS varactor and the second MOS varactor are connected to the circuit, to form a part of a first capacitor. The control voltage controls the voltages at the sources and the drains of the first MOS varactor and the second MOS varactor, thereby controlling the gate capacitors of the first MOS varactor and the second MOS varactor.

For the first MOS varactor and the second MOS varactor, it may be that both are N-channel MOS (N-channel MOS, NMOS) transistors or P-channel MOS (P-channel MOS, PMOS) transistors, or it may be that one is an NMOS transistor, and the other is a PMOS transistor.

The control voltage can control the gate capacitors of the first MOS varactor and the second MOS varactor. A gate capacitor of a MOS varactor is a capacitor of a gate of the MOS varactor. The gate capacitor of the MOS varactor includes a gate-source capacitor $C_{gs}$, a gate-drain capacitor $C_{gd}$, and a gate-bulk capacitor $C_{gb}$ that are connected in parallel. The control voltage may also be referred to as a switch (switch, SW) or a switching voltage. SW = 0 indicates that the SW is at a low level, and SW = 1 indicates that the SW is at a high level. A voltage of the low level may be a voltage of a ground line. A voltage of the high level may be a voltage of a power line.

The fixed capacitors and the MOS varactors are connected in series to implement voltage division. In this way, a change in a gate voltage of the MOS varactor caused by a power supply noise can be reduced. Therefore, a phase noise of the oscillator can be reduced.

The first bias voltage and the second bias voltage may be obtained through conversion of an output voltage of a power supply module, for example, may be obtained by using one or more voltage conversion circuits. The power supply module may provide electrical energy to another circuit in the chip. A power management module may convert a supply voltage provided by the power supply module. For example, a direct current (direct current, DC)-DC conversion circuit may convert the supply voltage provided by the power supply module. The DC-DC conversion circuit may be disposed on the chip. The power line is connected to the power supply module.

The first bias voltage VB1 and the second bias voltage VB2 may be bias voltages obtained from the supply voltage provided by the power line. It should be understood that: That the first bias voltage and the second bias voltage are bias voltages obtained from the supply voltage provided by the power line means that all of the first bias voltage, the second bias voltage, and the power line are provided with electrical energy by the power supply module in the chip. The first bias voltage and the second bias voltage may be obtained through conversion of the supply voltage provided by the power line, or may be obtained through conversion of a voltage at a point between the power supply module and the power line. The point between the power supply module and the power line may be a point on an interconnection line between the power supply module and the power line, or a point on a part/component between the power supply module and the power line. Both the manners in which the first bias voltage and the second bias voltage are obtained may be understood as that the first bias voltage and the second bias voltage are bias voltages obtained from the supply voltage provided by the power line.

A capacitance obtained when the first fixed capacitor and the first MOS varactor are connected in series is equal to a capacitance obtained when the second MOS varactor and the second fixed capacitor are connected in series. "Equal" may be understood as "approximately equal".

If capacitances of the first fixed capacitor and the second fixed capacitor are equal, the first MOS varactor and the second MOS varactor may be MOS varactors with a same process parameter or different process parameters.

To implement that the capacitance obtained when the first fixed capacitor and the first MOS varactor are connected in series is equal to the capacitance obtained when the second MOS varactor and the second fixed capacitor are connected in series, if process parameters of the first MOS varactor and the second MOS varactor are the same, the first bias voltage may be equal to the second bias voltage; or if process parameters of the first MOS varactor and the second MOS varactor are different, the first bias voltage may be different from the second bias voltage.

Two terminals N and P of the capacitor used in the differential oscillator may be separately connected to two output terminals of the differential oscillator.

Optionally, a bias voltage may be connected to a gate of a MOS varactor through a resistor. To be specific, the first bias voltage may be connected to the gate of the first MOS varactor through a resistor, and the second bias voltage may be connected to the gate of the second MOS varactor through a resistor.

When voltage values of the first bias voltage and the second bias voltage are properly designed, the phase noise of the oscillator can be reduced.

The first bias voltage may be within a first voltage range. When the first bias voltage is within the first voltage range, a gate capacitance of the first MOS varactor that is in at least one state of the control voltage does not change with an output voltage of the differential oscillator.

The second bias voltage may be within a second voltage range. When the second bias voltage is within the second voltage range, a gate capacitance of the second MOS varactor that is in at least one state of the control voltage does not change with an output voltage of the differential oscillator. If the process parameters of the first MOS varactor and the second MOS varactor are the same, the first voltage range is the same as the second voltage range.

The following provides a detailed description with reference to a specific embodiment, and details are not described herein.

FIG. 10 is a schematic structural diagram of a capacitor used in a differential oscillator according to an embodiment of this application.

The capacitor used in the differential oscillator includes a first fixed capacitor, a capacitor array, and a second fixed capacitor that are connected in series between two differential output terminals of the differential oscillator.

The capacitor array includes a plurality of capacitor units. Each capacitor unit includes two MOS varactors. Connections of a capacitor unit are used for description.

The first fixed capacitor is connected to a gate of a first MOS varactor, and a second fixed capacitor is connected to a gate of the second MOS varactor. A control voltage controls a bias voltage of a source and a drain of the first MOS varactor and a bias voltage of a source and a drain of the second MOS varactor. A bias voltage VB provides a direct current bias for the gates of the first MOS varactor and the second MOS varactor.

A capacitance of the first fixed capacitor is equal to a capacitance of the second fixed capacitor. Process parameters of the first MOS varactor and the second MOS varactor are the same.

When a voltage value of the bias voltage VB is properly designed, a phase noise of the oscillator can be reduced. The bias voltage may be within a first voltage range. When the bias voltage is within the first voltage range, a gate capacitance of the first MOS varactor that is in at least one state of the control voltage does not change with an output voltage of the oscillator. The following provides a detailed description with reference to a specific embodiment, and details are not described herein.

Optionally, the bias voltage VB may be connected to the gates of the two MOS varactors through resistors.

Both the sources and the drains of the two MOS varactors are controlled by a switching voltage.

A MOS varactor works in a depleted state or an inverted state. A gate capacitance of the MOS varactor in the depleted state is different from a gate capacitance of the MOS varactor in the inverted state. A capacitance of the MOS varactor existing when a gate voltage of the MOS varactor is in a state of SW = 1 is different from a capacitance of the MOS varactor existing when the gate voltage of the MOS varactor is in a state of SW = 0. Therefore, the MOS varactor can be configured to adjust a resonance frequency of a main resonant circuit of the oscillator. SW = 1 and SW = 0 are two states of the control voltage.

Both the two MOS varactors may be N-channel MOS (N-channel MOS, NMOS) transistors or P-channel MOS (P-channel MOS, PMOS) transistors.

FIG. 11 is a schematic diagram of a relationship between a gate voltage and a gate capacitance of a MOS varactor. In the figure, V represents the gate voltage of the MOS varactor, and C represents the gate capacitance of the MOS varactor.

When a bias voltage of a gate of the MOS varactor is within a range A1 or a range A3, a gate capacitance of the MOS varactor in a case of SW = 0 is equal to a gate capacitance of the MOS varactor in a case of SW = 1. In this case, the SW cannot control the gate capacitance of the MOS varactor. Therefore, to implement digital control of the gate capacitance of the MOS varactor, the bias voltage of the varactor is set to be within a range B 1, a range A2, or a range B2. "Equal" maybe "approximately equal".

With reference to the adjustable capacitors, in FIG. 8 to FIG. 10, that are used in main resonant circuits of differential oscillators, the two terminals N and P of the adjustable capacitor are separately connected to the circuit. The two terminals N and P of the adjustable capacitor may be separately connected to two output terminals of the differential oscillator. A change in a supply voltage affects voltages at the two terminals N and P of the adjustable capacitor. In other words, a power supply noise affects a gate voltage of the MOS varactor.

When the SW is 0, and the bias voltage of the gate of the MOS varactor is within the range B1, the gate capacitance of the MOS varactor changes with the gate voltage of the MOS varactor. The power supply noise affects an output voltage of the oscillator, and further affects the gate voltage of the MOS varactor. As a result, a capacitance of the MOS varactor changes, and an oscillation frequency of the oscillator is affected. Therefore, when the SW is 0, and the bias voltage that is of the gate of the MOS varactor and that is within the range B1 is used, the power supply noise affects the oscillation frequency of the oscillator. That is, power sensitivity of the oscillator is comparatively high, and a phase noise is comparatively large.

When the SW is 1, and the bias voltage of the gate of the MOS varactor is within the range B2, the gate capacitance of the MOS varactor changes with the gate voltage of the MOS varactor. The power supply noise affects an output voltage of the oscillator, and further affects the gate voltage of the MOS varactor. As a result, a capacitance of the MOS varactor changes, and an oscillation frequency of the oscillator is affected. Therefore, when the SW is 1, and the bias voltage that is of the gate of the MOS varactor and that is within the range B2 is used, the power supply noise affects the oscillation frequency of the oscillator. That is, power sensitivity of the oscillator is comparatively high, and a phase noise is comparatively large.

The gate voltage of the MOS varactor and the control voltage may be two different input voltages. Usually, the bias voltage of the gate of the MOS varactor is almost not related to the control voltage SW. Therefore, when the bias voltage of the gate of the MOS varactor is within the range B1 or B2, the phase noise is comparatively large.

For a same MOS varactor, a larger difference between a voltage value in the case of SW = 0 and a voltage value in the case of SW = 1 indicates a larger difference between B1 and B2, in other words, a larger voltage range of A2.

Due to a process limitation, the gate capacitance of the MOS varactor may change quite slowly with the gate voltage, and there is no voltage range of A2.

FIG. 12 is a schematic diagram of a relationship between a gate voltage and a gate capacitance of a MOS varactor. In the figure, V represents the gate voltage of the MOS varactor, and C represents the gate capacitance of the MOS varactor.

For the adjustable capacitor shown in FIG. 9 or FIG. 10, when a bias voltage of a gate of the MOS varactor is within a range A1 or a range A3, a gate capacitance of the MOS varactor in a case of SW = 0 is equal to a gate capacitance of the MOS varactor in a case of SW = 1. In this case, the SW cannot control the gate capacitance of the MOS varactor. Therefore, to implement digital control of the gate capacitance of the MOS varactor, the bias voltage of the varactor is set to be within a range B1, a range C1, or a range B2.

When the bias voltage of the gate of the MOS varactor is within the range B1: In the case of SW = 0, a power supply noise affects an output voltage of the oscillator, and further affects the gate voltage of the MOS varactor, and as a result, a capacitance of the MOS varactor changes with the power supply noise; or in the case of SW = 1, a power supply noise does not affect an output voltage of the oscillator, and a capacitance of the MOS varactor does not change with the power supply noise.

When the bias voltage of the gate of the MOS varactor is within the range B2: In the case of SW = 1, a power supply noise affects an output voltage of the oscillator, and further affects the gate voltage of the MOS varactor, and as a result, a capacitance of the MOS varactor changes with the power supply noise; or in the case of SW = 0, a power supply noise does not affect an output voltage of the oscillator, and a capacitance of the MOS varactor does not change with the power supply noise.

When the bias voltage of the gate of the MOS varactor is within the range C1, for both the cases of SW = 0 and SW = 1, a power supply noise affects an output voltage of the oscillator, and further affects the gate voltage of the MOS varactor, and as a result, a capacitance of the MOS varactor changes with the power supply noise.

Usually, the bias voltage of the gate of the MOS varactor is almost not related to the SW. Therefore, when the bias voltage of the gate of the MOS varactor is within the range C1, a phase noise of the differential oscillator is comparatively large regardless of SW = 0 or SW = 1.

A voltage bias region in which the gate capacitance of the MOS varactor changes drastically with the gate voltage is a high kpush region (high kpush region), namely, a region with high power sensitivity, for the oscillator. A voltage range of the high power sensitive region may be determined based on a voltage value of the SW and a physical parameter of the MOS varactor. For a case shown in FIG. 12, the range C1 is a high kpush region (high kpush region).

With reference to the relationships between the gate voltage and the gate capacitance of the MOS varactor in FIG. 11 and FIG. 12, for a differential oscillator using the adjustable capacitor shown in FIG. 10, when the bias voltage of the gate of the MOS varactor is properly designed, impact of a power supply noise on an oscillation frequency of the oscillator can be reduced, and the phase noise of the oscillator can be reduced.

The bias voltage may be set to be within the first voltage range. When the bias voltage is within the first voltage range, the gate capacitance of the first MOS varactor that is in at least one state of the control voltage does not change with the output voltage of the oscillator. The control voltage is used to control the gate capacitance of the first MOS varactor. The control voltage may be the SW. The states of the control voltage may include a state of SW = 0 and a state of SW = 1. Based on a voltage value of the control voltage, the states of the control voltage may further include another state. This is not limited in this embodiment of this application.

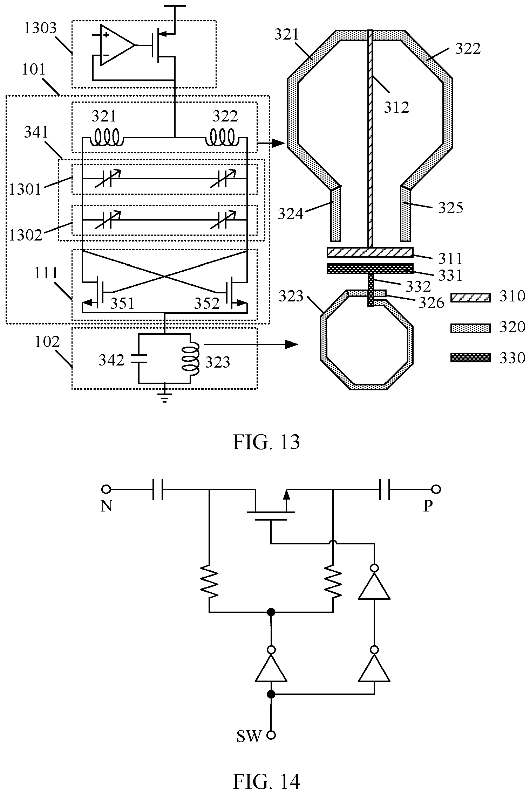

FIG. 13 shows a differential oscillator according to an embodiment of this application. The oscillator uses a tail inductor resonance technology.

The oscillator includes a power line 311, a ground line 331, a main resonant circuit 101, a tail resonant circuit 102, and a voltage regulator 1303.

The power line 311 is disposed on a chip. The ground line 331 is disposed on the chip and is parallel to the power line 311. The power line 311 and the ground line 331 divide a chip region in which the differential oscillator is located into the following parts: a first part that is located between the power line 311 and the ground line 331, and a second part and a third part that are separately located on two sides of the power line 311 and the ground line 331.

A voltage provided by a power supply module of the chip may be connected to the power line after passing through the voltage regulator 1303, to supply power to an entire resonant circuit and provide a stable voltage bias. The voltage regulator 1303 may be a low dropout linear regulator (low dropout regulator, LDO), or the like. The LDO may output a voltage with an ultra-low noise. The voltage provided by the power supply module has a comparatively small noise after passing through the voltage regulator 1303.

The main resonant circuit is disposed on the chip. The main resonant circuit may include a first capacitor 341. The first capacitor 341 may be an adjustable capacitor. The main resonant circuit may include a first inductor 321 and a second inductor 322 that have a same inductance. A first adjustable capacitor 1301 and a second adjustable capacitor 1302 in the adjustable capacitor are connected in parallel. The first inductor 321 and the second inductor 322 are disposed in the second part. For example, the first inductor 321 and the second inductor 322 are disposed on a side that is of the power line 311 and that is far away from the ground line 331.

The first inductor 321 and the second inductor 322 in the main resonant circuit may be disposed symmetrically. "Symmetrically" includes "approximately symmetrically". The first inductor 321 and the second inductor 322 may be separately disposed in a surrounding shape such as an octagon or a hexagon. Alternatively, the first inductor 321 and the second inductor 322 may jointly form a surrounding shape such as an octagon or a hexagon, where lower edges of the surrounding shape may not be connected.

For the first adjustable capacitor 1301 in the main resonant circuit, refer to a capacitor structure shown in FIG. 14.

For the second adjustable capacitor 1302 in the main resonant circuit, refer to a capacitor structure shown in FIG. 10.

The tail resonant circuit includes a tail inductor and a tail capacitor 342.

The tail resonant circuit is disposed on the chip. The tail inductor includes a tail inductor body 323 and a tail inductor connection portion 326. The tail inductor body 323 is disposed in the third part. For example, the tail inductor body 323 is disposed on a side that is of the ground line 331 and that is far away from the power line 311. The tail inductor connection portion 326 is configured to connect to the tail inductor body 323 and the tail capacitor. The tail inductor body 323 may be disposed in a surrounding shape such as an octagon or a hexagon.

The main resonant circuit includes a negative resistor 111. The negative resistor may be cross-coupled MOS transistors. Process parameters of a first MOS transistor 351 and a second MOS transistor 352 are the same, and the first MOS transistor 351 and the second MOS transistor 352 are cross-connected in a coupling manner. The cross-connected MOS transistors may serve as a negative resistor. The cross-coupled MOS transistors may be equivalent to a linear negative resistor. The cross-coupled MOS transistors may provide energy to the main resonant circuit, to compensate for a loss of the main resonant circuit and maintain oscillation. The cross-coupled MOS devices 111 may be disposed on the chip.

Optionally, a capacitor may be formed on the chip as a capacitor in the main resonant circuit and/or a capacitor in the tail resonant circuit. For example, a MOM capacitor or a MIM capacitor may be formed on the chip that uses the foregoing layout manner.

A distance between the ground line and the power line may be less than or equal to a first preset value.

Because the distance between the power line 311 and the ground line 331 is comparatively small, when a comparatively small decoupling capacitor is disposed between the power line 311 and the ground line 331, an alternating current impedance between the power line and the ground line can meet a circuit design requirement. Therefore, when the power line and the ground line are disposed adjacently, a requirement of the oscillator for the decoupling capacitor can be reduced. The decoupling capacitor may be disposed in the first part.

Because the distance between the power line and the ground line is comparatively small, a parasitic capacitance between the power line 311 and the ground line 331 is comparatively large. Therefore, for an alternating current signal, the impedance between the power line and the ground line is comparatively small, and precise parasitic parameters of the MOS transistors are obtained. Based on the precise parasitic parameters of the cross-coupled MOS devices, the main resonant circuit and the tail resonant circuit can be properly designed, so that the tail resonant circuit resonates at an oscillation frequency twice an oscillation frequency of the main resonant circuit. This reduces a phase noise.

The tail inductor connection portion 326 is disposed in parallel with the ground line 331. The tail inductor connection portion is configured to connect the tail inductor body 323 to another component in the oscillator. For example, the tail inductor connection portion may be configured to connect the tail inductor body 323 to the tail capacitor 342 and the cross-coupled MOS transistors. The tail inductor connection portion 326 is located between the tail inductor body 323 and the ground line 331.

FIG. 14 is a schematic circuit diagram of an adjustable capacitor of a differential oscillator.

In a digitally controlled oscillator, a value of a capacitance C may be changed through digital control. In a digital control manner, usually, "0" is used to represent a low level, and "1" is used to represent a high level. The low level may be a "ground" in a circuit, in other words, a zero potential, and the high level may be a supply voltage.

The adjustable capacitor includes two fixed capacitors and one MOS transistor that serves as a voltage controlled capacitor. The MOS transistor is controlled by an SW. The MOS transistor may be a switching MOS transistor, to implement a voltage controlled capacitor. A capacitor $C_{ds}$ between a source and a drain of the MOS transistor is connected to the two fixed capacitors in series. A gate of the MOS transistor is controlled by the SW. The SW is connected to the gate of the MOS transistor by using two phase inverters, to improve a driving capability of the SW. In addition, the SW controls voltages at the source and drain of the MOS transistor. The SW is connected to the source and drain of the MOS transistor by using one phase inverter. Points N and P are separately connected to a first inductor 321 and a second inductor 322 in a main resonant circuit. In other words, the points N and P are separately connected to two output terminals of a differential resonant circuit. The point N is connected to one fixed capacitor, and the point P is connected to the other fixed capacitor. The two fixed capacitors may be MOM capacitors, or may be another type of capacitors. The two fixed capacitors are separately connected to the source and drain of the MOS transistor.

The MOS transistor is controlled by the SW. The MOS transistor may be a switching MOS transistor. When the MOS transistor is turned on, an impedance between the source and drain of the MOS transistor is quite small, the MOM capacitors are connected to the circuit in series, and a capacitance is comparatively large. When the MOS transistor is turned off, an impedance between the source and drain of the MOS transistor is quite large, the MOM capacitors and the parasitic capacitor $C_{ds}$ of the MOS transistor are connected to the circuit, and a capacitance between the point N and the point P is comparatively small because $C_{ds}$ has a comparatively small capacitance.

A value of an adjustable capacitance is controlled by using a switch, and a frequency is changed and a function of digital frequency control is implemented.

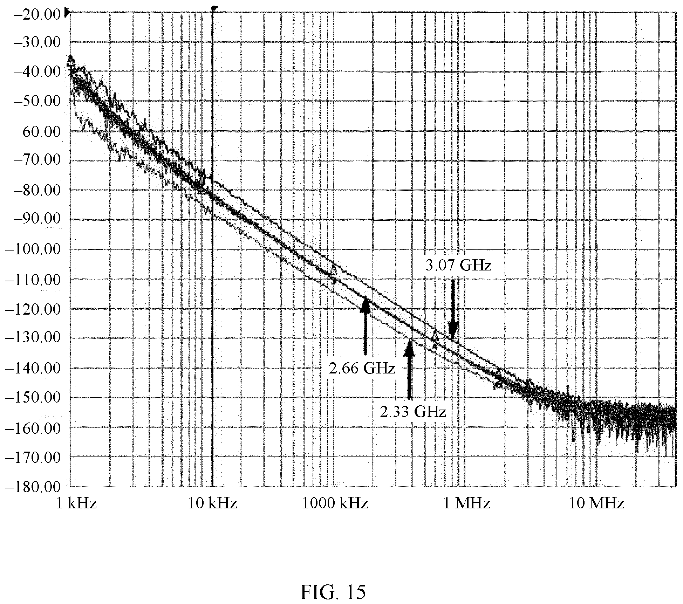

FIG. 15 is a schematic diagram of a test result of a differential oscillator according to an embodiment of this application. The differential oscillator provided in FIG. 13 is tested, and a test result is shown in FIG. 15. A frequency of the oscillator may cover 2.33 GHz to 3.07 GHz. When the frequency of the oscillator is 3 GHz, a phase noise tested at a frequency offset (offset frequency) of 800 kHz is -130 dBc/Hz, thereby achieving a phase noise result of a best oscillator in the industry.

An embodiment of this application provides a chip, including the differential oscillator described above.

In the embodiments of this application, "at least one" means one or more, and "a plurality of' means two or more. The term "and/or" describes an association relationship for describing associated objects and represents that three relationships may exist. For example, A and/or B may represent the following three cases: Only A exists, both A and B exist, and only B exists, where A and B may be singular or plural. The character "/" generally indicates an "or" relationship between the associated objects. "At least one of the following items" or a similar expression thereof represents any combination of these items, including a single item or any combination of a plurality of items. For example, "at least one of a, b, and c" may represent a, b, c, a-b, a-c, b-c, or a-b-c, where a, b, and c may be singular or plural. It may be clearly understood by a person skilled in the art that, for the purpose of convenient and brief description, for a detailed working process of the foregoing system, apparatus, and unit, refer to a corresponding process in the foregoing method embodiments, and details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A differential oscillator, comprising:

    a power line, disposed on a chip;
    a ground line, disposed on the chip and parallel to the power line;
    a main resonant circuit, disposed on the chip and comprising a first inductor and a second inductor, wherein the first inductor and the second inductor are disposed on a side that is of the power line and that is far away from the ground line, and the main resonant circuit is connected to the power line; and
    a tail resonant circuit, disposed on the chip and connected to the main resonant circuit and the ground line.

2. The differential oscillator according to claim 1, wherein
    the tail resonant circuit comprises a tail inductor, wherein the tail inductor comprises a tail inductor body and a tail inductor connection portion, the tail inductor body is disposed on a side that is of the ground line and that is far away from the power line, and the tail inductor connection portion is configured to connect to the tail inductor body and the main resonant circuit.

3. The differential oscillator according to claim 1 or 2, further comprising a decoupling capacitor, wherein the decoupling capacitor is disposed between the ground line and the power line, and is connected to the power line and the ground line.

4. The differential oscillator according to any one of claims 1 to 3, wherein the tail inductor connection portion is disposed in parallel with the ground line, and the tail inductor connection portion is located between the tail inductor body and the ground line.

5. The differential oscillator according to any one of claims 1 to 4, wherein the main resonant circuit comprises cross-coupled metal-oxide-semiconductor, MOS, transistors, and the cross-coupled MOS transistors are configured to provide negative resistance for the main resonant circuit.

6. The differential oscillator according to any one of claims 1 to 5, wherein

    the main resonant circuit comprises a first capacitor, and the first capacitor comprises a first fixed capacitor, a first MOS varactor, a second MOS varactor, and a second fixed capacitor, wherein
    the first fixed capacitor is connected to a gate of the first MOS varactor, and the second fixed capacitor is connected to a gate of the second MOS varactor; a control voltage is a bias voltage of a source and a drain of the first MOS varactor and a bias voltage of a source and a drain of the second MOS varactor; a first bias voltage provides a direct current bias for the gate of the first MOS varactor, a second bias voltage provides a direct current bias for the gate of the second MOS varactor, and the first bias voltage and the second bias voltage are bias voltages obtained from a supply voltage provided by the power line; and a sum of a capacitance of the first fixed capacitor and a capacitance of the first MOS varactor is equal to a sum of a capacitance of the second MOS varactor and a capacitance of the second fixed capacitor.

7. The differential oscillator according to claim 6, wherein when the first bias voltage is within a first voltage range, a gate capacitance of the first MOS varactor that is in at least one voltage value state of the control voltage does not change with a voltage at a terminal at which the first fixed capacitor is connected to the first inductor.

8. The differential oscillator according to claim 6 or 7, wherein capacitances of the first fixed capacitor and the second fixed capacitor are equal, process parameters of the first MOS varactor and the second MOS varactor are the same, and the first bias voltage and the second bias voltage are equal.

9. A differential oscillator, comprising a main resonant circuit that is disposed on a chip, wherein

the main resonant circuit comprises a first fixed capacitor, a first metal-oxide-semiconductor MOS varactor, a second MOS varactor, and a second fixed capacitor; and
the first fixed capacitor is connected to a gate of the first MOS varactor, and the second fixed capacitor is connected to a gate of the second MOS varactor; a control voltage is a bias voltage of a source and a drain of the first MOS varactor and a bias voltage of a source and a drain of the second MOS varactor; a first bias voltage provides a direct current bias for the gate of the first MOS varactor, a second bias voltage provides a direct current bias for the gate of the second MOS varactor, and the first bias voltage and the second bias voltage are bias voltages obtained from a supply voltage provided by a power line; and a sum of a capacitance of the first fixed capacitor and a capacitance of the first MOS varactor is equal to a sum of a capacitance of the second MOS varactor and a capacitance of the second fixed capacitor.

10. The differential oscillator according to claim 9, wherein the main resonant circuit comprises a first inductor; and when the first bias voltage is within a first voltage range, a gate capacitance of the first MOS varactor that is in at least one voltage value state of the control voltage does not change with a voltage at a terminal at which the first fixed capacitor is connected to the first inductor.

11. The differential oscillator according to claim 9 or 10, wherein capacitances of the first fixed capacitor and the second fixed capacitor are equal, process parameters of the first MOS varactor and the second MOS varactor are the same, and the first bias voltage and the second bias voltage are equal.

12. The differential oscillator according to any one of claims 9 to 11, comprising cross-coupled metal-oxide-semiconductor MOS transistors, wherein the cross-coupled MOS transistors are configured to provide negative resistance for the main resonant circuit.

13. The differential oscillator according to any one of claims 9 to 12, comprising:

a power line, disposed on the chip;
a ground line, disposed on the chip and parallel to the power line;
wherein the main resonant circuit further comprises a second inductor, the first inductor and the second inductor are disposed on a side that is of the power line and that is far away from the ground line, and the main resonant circuit is connected to the power line; and
a tail resonant circuit, disposed on the chip.

14. The differential oscillator according to claim 13, wherein
the tail resonant circuit comprises a tail inductor, wherein the tail inductor comprises a tail inductor body and a tail inductor connection portion, the tail inductor body is disposed on a side that is of the ground line and that is far away from the power line, and the tail inductor connection portion is configured to connect to the tail inductor body and the main resonant circuit.

15. The differential oscillator according to claim 13 or 14, comprising a decoupling capacitor, wherein the decoupling capacitor is disposed between the ground line and the power line, and is connected to the power line and the ground line.

16. The differential oscillator according to any one of claims 13 to 15, wherein the tail inductor connection portion is disposed in parallel with the ground line, and the tail inductor connection portion is located between the tail inductor body and the ground line.

FIG. 1

FIG. 2

FIG. 3

FIG. 4

FIG. 5

FIG. 6

FIG. 7

SW<N:1>

FIG. 8

FIG. 9

VB

A plurality of

N

SW<N:1>

P

## FIG. 10

C

| A1 | B1 | A2 | B2 | A3 |

—— SW=0

- - SW=1

t

V

V

## FIG. 11

C

| A1 | B1 | C1 | B2 | A3 |

—— SW=0

- - SW=1

t

V

V

## FIG. 12

FIG. 13

FIG. 14

FIG. 15

## INTERNATIONAL SEARCH REPORT

| International application No. |
| --- |
| **PCT/CN2019/081920** |

| **A.** | **CLASSIFICATION OF SUBJECT MATTER** |
| --- | --- |

H03B 5/08(2006.01)i; H03B 5/12(2006.01)i

According to International Patent Classification (IPC) or to both national classification and IPC

| **B.** | **FIELDS SEARCHED** |
| --- | --- |

Minimum documentation searched (classification system followed by classification symbols)

H03B5

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; CNKI; IEEE: 振荡器, 差分, 压控, 电压控制, 电源线, 地线, 平行, 芯片, 主谐振, 尾谐振, 尾部, 尾, 电容, 电感, 谐振, 变容, MOS, VCO, LC, differential, oscillator, power line, GND, ground line, resonance, inductor, capacitor, parallel, IC, chip

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| X | CN 103404032 A (QUALCOMM INCORPORATED) 20 November 2013 (2013-11-20) description, paragraphs [0041] and [0042], and figure 8 | 9-12 |
| A | CN 103404032 A (QUALCOMM INCORPORATED) 20 November 2013 (2013-11-20) entire document | 1-8, 13-16 |
| A | CN 106505948 A (UNIVERSITY OF SCIENCE AND TECHNOLOGY OF CHINA) 15 March 2017 (2017-03-15) description, paragraphs [0026]-[0031], and figure 3 | 1-16 |
| A | CN 104852732 A (INSTITUTE OF ADVANCED TECHNOLOGY, UNIVERSITY OF SCIENCE AND TECHNOLOGY OF CHINA) 19 August 2015 (2015-08-19) entire document | 1-16 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 November 2019** | **04 December 2019** |

| Name and mailing address of the ISA/CN | Authorized officer |
| --- | --- |
| **China National Intellectual Property Administration (ISA/CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

INTERNATIONAL SEARCH REPORT

Information on patent family members

International application No.

**PCT/CN2019/081920**

| Patent document cited in search report | | | Publication date (day/month/year) | Patent family member(s) | | | Publication date (day/month/year) |
|---|---|---|---|---|---|---|---|
| CN | 103404032 | A | 20 November 2013 | KR | 20130131467 | A | 03 December 2013 |
| | | | | US | 2012223771 | A1 | 06 September 2012 |
| | | | | JP | 5823541 | B2 | 25 November 2015 |
| | | | | WO | 2012119123 | A3 | 10 January 2013 |
| | | | | US | 8803616 | B2 | 12 August 2014 |
| | | | | EP | 2681845 | B1 | 27 December 2017 |
| | | | | KR | 101575775 | B1 | 08 December 2015 |
| | | | | CN | 103404032 | B | 02 November 2016 |
| | | | | WO | 2012119123 | A2 | 07 September 2012 |
| | | | | EP | 2681845 | A2 | 08 January 2014 |
| | | | | JP | 2015165678 | A | 17 September 2015 |
| | | | | IN | 201306601 | P4 | 17 June 2016 |
| | | | | JP | 2014509149 | A | 10 April 2014 |
| | | | | JP | 6092286 | B2 | 08 March 2017 |
| CN | 106505948 | A | 15 March 2017 | None | | | |
| CN | 104852732 | A | 19 August 2015 | CN | 104852732 | B | 05 September 2017 |

Form PCT/ISA/210 (patent family annex) (January 2015)